(19) Europäisches Patentamt
European Patent Office
Office européen des brevets

(11) **EP 2 056 659 A1**

(12) **EUROPEAN PATENT APPLICATION**

(43) Date of publication:
**06.05.2009 Bulletin 2009/19**

(51) Int Cl.:
***H05K 7/20*** (2006.01)

(21) Application number: **08157001.2**

(22) Date of filing: **27.05.2008**

| | |
|---|---|
| (84) Designated Contracting States:<br>**AT BE BG CH CY CZ DE DK EE ES FI FR GB GR HR HU IE IS IT LI LT LU LV MC MT NL NO PL PT RO SE SI SK TR**<br>Designated Extension States:<br>**AL BA MK RS**<br><br>(71) Applicant: **ABB Research LTD**<br>**8050 Zurich (CH)** | (72) Inventors:<br>• **Yesin, Berk**<br>**CH-8038, Zürich (CH)**<br>• **Agostini, Bruno**<br>**CH-8953, Dietikon (CH)**<br><br>(74) Representative: **ABB Patent Attorneys**<br>**c/o ABB Schweiz AG,**<br>**Intellectual Property (CH-LC/IP),**<br>**Brown Boveri Strasse 6**<br>**5400 Baden (CH)** |

(54) **Electronic System**

(57) The invention relates to an electronic system including a plurality of electronic components (11, 12, 13). Each of the electronic components (11, 12, 13) generates an individual amount of heat. The heat is dissipated by means of a common airflow (10). At least one of the plurality of electronic components (12, 13) is in thermal contact with an evaporator section (16) of a two-phase cooling circuit (15). The two-phase cooling circuit (15) transfers the heat generated by this at least one electronic component (12, 13) being in thermal contact therewith to a location in the airflow (10) distant from the location where the heat is generated.

Fig. 3

**Description**

The invention relates to an electronic system including a plurality of electronic components.

Many electric devices such as AC motors for example need power electronic systems as well as control electronics. The electronic components needed for operating such an electric device are in many cases included in a housing which is constructed in order to comply with the required ingress protection rating (IP). In many cases the housing or enclosure that encloses the electronic components protects the electronic components from being touched or being exposed to environmental influences.

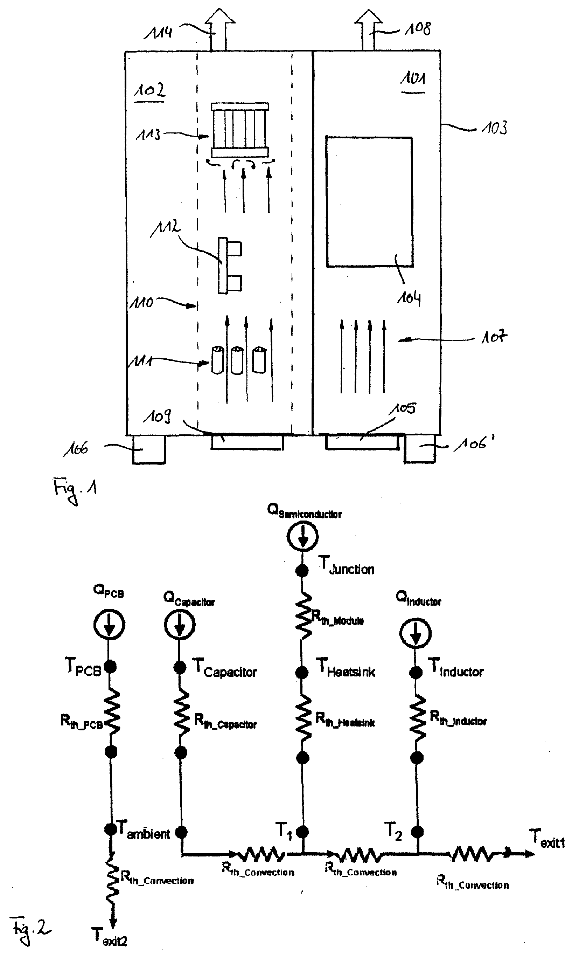

An exemplary schematic illustration of such an electronic system is shown in figure 1. All of the electronic components necessary to control an AC motor in the given example are enclosed either in a first area 101 or a second area 102. Both areas 101 and 102 are arranged beside each other in a common housing separated by a wall.

In the first area 101 a printed circuit board (PCB) 104 is arranged. On such a printed circuit board 104 the control electronics are arranged. In order to dissipate the heat which is generated by the electronic components of the printed circuit board 104 a first air fan 105 is mounted at the bottom side of housing 103. As the first air fan 105 is located at the bottom side of housing 103 it is easy to prevent liquids from coming inside housing 103. In the illustrated embodiment stands 106 and 106' are shown only for illustrative reasons in order to show that the first air fan 105 is arranged at the bottom side. By stands 106 and 106' housing 103 may stand on a platform of any type of construction.

The first air fan 105 generates an air flow indicated by arrows 107. The printed circuit board 104 is arranged to lie within the airflow 107. Thereby the airflow generated by the first air fan 105 is in thermal contact with the electronic components being arranged on printed circuit board 104. The generated heat of the electronic components or devices of the printed circuit board 104 is consequently dissipated by the airflow 107 and transferred outside of the first area 101 of housing 103. The exiting airflow containing the dissipated heat is indicated by arrow 108.

In the second area 102 power electronic components are arranged. Such power electronic components may be for example a number of capacitors 111 as well as an arrangement of power semiconductors 112 and choke inductors 113. Inside second area 102 another airflow 110 is generated by means of a second air fan 109. As well as the first air fan 105 the second air fan 109 is also arranged at the bottom side of housing 103. Locating air fans 105 and 109 at the bottom side has not only the advantage that liquids are prevented from being introduced to the inside of housing 103 but also that the heated airflow is exiting at the top side of housing 103. Thereby the convection direction of a heated airflow as well as the generated direction by air fans 105 or 109 are the same.

It is thus evident that the given example is only used for illustrative purposes. Of course other electronic devices or components and in particular also constructions other than for an AC motor can comprise an electronic system for controlling and supplying such equipment. Coming back to the example for controlling and supplying an AC motor the electronic components 111, 112 and 113 being arranged inside that second area 102 have different operating temperatures that are allowed before a damage of the respective electronic component has to be feared. In the given example a maximum allowed operating temperature for the capacitors 111 may be for example 75°C, for the power semiconductors 112 125°C and for the choke inductors 113 150°C. According to the arrangements as known from the prior art these allowed temperatures define the arrangement of the electronic components 111, 112 and 113 in the air-stream or airflow generated by the second air fan. So an airflow through the second area 102 of housing 103 will have an increasing temperature starting at ambient temperature at the side of the air fan 109 and being highest at the exit side when the heat of the electronic components 111, 112 and 113 is dissipated by the airflow 110. This is illustrated with arrow 114 which represents the heated airflow 110 exiting.

Fig. 2 shows a model of such a mechanical layout as shown in fig. 1. On the very left side the arrangement of the first area 101 is shown with a heat amount $Q_{PCB}$ of the printed circuit board 104. The introduced airflow 107 starts at an ambient temperature $T_{ambient}$ at exit with an exit temperature $T_{exit2}$. The temperature drop across the components and devices of the printed circuit board 104 in this case is modelled as a thermal resistance $R_{th\_PCB}$.

As all of the other components being arranged in a common airflow 110 the generated heat amounts $Q_{capacitor}$, Qsemiconductor and $Q_{inductor}$ have to be dissipated by the common airflow 110. The respective temperatures of the electronic components 111, 112 and 113 are named with $T_{capacitor}$, $T_{junction}$ and $T_{inductor}$. Usually the power semiconductors 112 are mounted on a common heat sink so that the thermal resistance of electronic component 112 representing the power semiconductors comprises consecutive parts which are denoted with $R_{th\_module}$ and $R_{th\_heatsink}$. The other thermal resistances of capacitors 111 and choke inductors 113 are denoted with $R_{th\_capacitor}$ and $R_{th\_inductor}$ respectively. As well as in the case of the printed circuit board 104 the introduced airflow 110 starts at an ambient temperature $T_{ambient}$. Passing any of the electronic components 111, 112 or 113 the temperature of this airflow 110 will increase thereby generating the following sequence of airflow temperatures : $T_{ambient} < T_1 < T_2 < T_{exitl}$

The increase of the temperature T of the airflow 110 is modelled with a negative thermal resistance $R_{th\_convection}$. This negative thermal resistance is approximated from the specific heat $C_p$ and a mass flow rate dm/dt of the generated airflow 110. It is perfectly clear from the model that an increasing airflow 110 results in a decreasing thermal resistance $R_{th\_convection}$ which is approximated by $R_{th\_convection} = (-1) / (C_p * dm/dt)$. So a pressure drop over any of the electronic components in the airflow deteriorates the cooling performance of the electronic system. Unfortunately most of the electronic components are only designed with respect to their electronic characteristics but cause a large pressure drop if located in a cooling airflow. In the given example this is in particular true for the choke inductors 113. Furthermore the need to locate electronic components with higher temperatures nearer to the exit of the housing 103 often results in locating heavy components at the very top end of second area 102. This results in a disadvantageous centre point of gravity with respective stability problems of the overall arrangement.

Thus, it is an object of the present invention to create an improved electronic system with means for cooling electronic components thereof.

This problem is solved by an electronic system according to claim 1.

According to the present invention the electronic system includes a plurality of electronic components. Each of these electronic components generates an individual amount of heat. The heat generated by the electronic components is dissipated by means of a common airflow. According to the present invention at least one of the plurality of electronic components is in thermal contact with an evaporator section of a two-phase cooling circuit. The two-phase cooling circuit transfers the heat generated by the at least one electronic component in thermal contact with the evaporator section to a location in the airflow distant to the location where the heat was generated.

By use of the two-phase cooling circuit the design of the electronic system is not longer bound to the heat-stack-design as known from the prior art. It is rather possible to design the electronic system with regard to other aspects for example a more compact design or an increased stability by locating heavy electronic components near to the bottom of a housing. Nevertheless, the heat amount being generated by the electronic components can be dissipated in the common airflow in a sequence with respect to the temperatures or heat amounts generated by the electronic components. Further advantages are a subject to the subclaims.

It is particularly advantageous to define the location in the airflow to which the generated heat is transferred by means of the two-phase cooling circuit by the allowed temperatures of the electronic components which are arranged in the airflow and a temperature of a condensing section of the two-phase cooling circuit. Instead of placing the heat generating electronic component in the airflow it is thereby possible to arrange such an electronic component outside the airflow and in thermal contact with an evaporator section of the two-phase cooling circuit thereby improving the mass flow of the airflow through the arrangement of electronic components.

Furthermore it is advantageous when the condenser section of the two-phase cooling circuit comprises a condenser and a cooling element being in contact therewith whereby the cooling element is arranged to be located in the airflow. Such a cooling element can be designed in order not to disturb the airflow badly and thereby also leading to an improved airflow. Such an improved airflow with a reduced pressure drop in the end improves the overall cooling of all of the electronic components to be cooled by this common airflow.

In most cases it will be advantageous to improve the airflow by means of an air fan. But such an air fan is not necessarily provided. The sequential arrangement as already explained with regard to the prior art may also utilize a convection air-stream.

It is furthermore advantageous to arrange those electronic components in thermal contact with the evaporator section of the two-phase cooling circuit which generate the largest amount of heat and/or cause the highest pressure drop when located in the airflow. The selection of those electronic components causing the highest pressure drop and/or generating the largest amount of heat has the advantage that the limiting factor of improving the cooling according to the state of the art shown in figure 1 is eliminated.

Further advantages will be clear from the detailed description following hereafter using the illustrative embodiments of the drawing for further explanations.

Fig. 1    shows an exemplary layout of an electronic system according to the prior art,

fig. 2    shows a thermal model thereof,

fig. 3    shows an exemplary embodiment of the present invention,

fig. 4    shows a first model of the arrangement of fig. 3 and

fig. 5    shows a thermal model of an adapted arrangement of fig. 3.

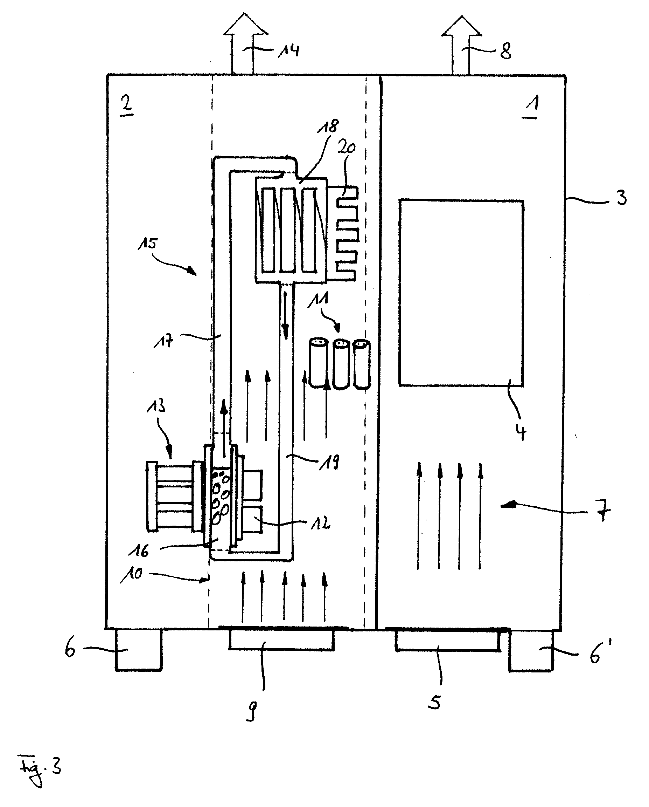

To simplify matters, the example of fig. 3 relates also to a control and supply system of an AC motor. Consequently also the first area 1 and the second area 2 are constituted in a common housing 3. First area 1 encloses the PCB 4 which is cooled by an airflow 7 generated by a first air fan 5. The direction of the air flow is again directed in a vertical direction with an entrance at the bottom side of housing 3 that is rested on stands 6, 6'. The heated airflow exits thereby dissipating heat from the PCB 4 as indicated by arrow 8.

In the second area 2 the power electronic components are arranged. With regard to the present invention the arrangement of second area 2 is meant to be the electronic system. This is to be used as further electronic systems may exist complementing the inventive one. Inside second area 2 an airflow 10 is generated by means of a second air fan 9. The second air fan 9 is arranged adjacent to the first air fan 5 also at the bottom side of housing 3. Contrary to the example of the state of the art shown in fig. 1 the electronic components are not arranged with respect to the allowed temperature in the airflow 10. In fact the power semiconductor mdules 12 and the choke inductors 13 are arranged to be in thermal contact with an evaporator section 16 of a two-phase cooling circuit 15. Two-phase cooling circuit 15 comprises an evaporator section 16 and a condenser section 18. The evaporator section is connected to the condenser section 18 by means of a feeder line 17 in order to convey vapor generated by heating a liquid in the evaporator section 16 to its boiling temperature. The vapor which is conveyed to the condenser section 18 is cooled down to fall back under the boiling temperature again. Consequently the vapor condenses and liquid is returned to the evaporator section 16 by means of a return line 19.

It is self-evident that the illustrated two-phase cooling circuit 15 can only serve as an example for such cooling circuits. For example a heat pipe or thermosyphon may also serve the same purpose. The method of operation of such cooling circuits is well known in the art and a more detailed description thereof may be omitted. In order to improve the cooling of the vapor inside condenser section 18 the condenser section comprises a condenser and a cooling element 20 for example a heat sink made of aluminium being in thermal contact therewith. The condenser section 18 is arranged to be in the airflow 10 which is indicated by the dotted lines. By the use of the two-phase cooling circuit 15 the amount of heat which is generated by the power semiconductors 12 and the choke inductors 13 is dissipated by the airflow 10 at a location in the airflow 10 which is independent of the location at which the heat was generated. Thereby it is possible to arrange for example the capacitors 11 representing in general electronic components that are allowed to have a temperature less than the allowed temperature of the power semiconductors 12 or even the choke inductors 13 upstream of the condenser section 18. Thus, the "heat-stack-layout" is realised by the capacitors 11 and the condenser section 18 that has a higher temperature than the capacitors 11.

By means of the two-phase cooling circuit 15 it is possible on the one hand to position the choke inductors 13 which are the heaviest of the electronic components to be arranged inside the second area 2 near the bottom of housing 3. This increases the stability of the overall arrangement of the electronic system. On the other hand the choke inductors 13 and the power semiconductors 12 which generate the largest amount of heat inside the second area 2 are both in contact with the evaporator section 16 of the two-phase cooling circuit 15. It is thereby clear that by using such a two-phase cooling circuit 15 the electronic components may be arranged inside the second area 2 without considering their position in the airflow 10. Instead of the temperature of the electronic components 12 and 13 it is only necessary to consider the temperature of the condensing section 18. But as the location of the condenser section 18 and the electronic components 12 and 13 is decoupled by the use of the two-phase cooling circuit 15 it is nevertheless possible to introduce the heat generated by a power semiconductor 12 and choke inductors 13 to a location in the airflow 10 in such that "heat stacking" as known from the prior art is achieved.

With regard to the present example this means that the capacitors 11 which are very limited in their allowed temperature range are arranged upstream of the condenser section 18 that may even work at a higher temperature compared to the allowed temperature of the capacitors 11.

It is furthermore clear that the airflow 10 is not as sharply limited as indicated by the dotted lines. These lines are only used for illustrative reasons in order to show that electronic components that could cause a high pressure drop if located in the main air-stream are advantageously located outside the air flow 10. In fig. 3 it is definitely illustrated by moving the choke inductors 13 to the left side of the drawing thereby enlarging the distance between the main air-stream and the inductors 13.

On the other hand it is possible as it is shown with regard to power semiconductors 12 that the power semiconductors 12 are also located in the airflow 10 but that the main heat generated by the power semiconductors 12 is transferred by means of the two-phase cooling circuit 15 to a position or location inside the airflow 10 downstream of other electronic components such as capacitors 11 which are operable at a lower temperature.

It must be emphasized that the given example is in no way limiting to the invention. In particular the expression "electronic component" may comprise any group of elements or discrete devices as well.

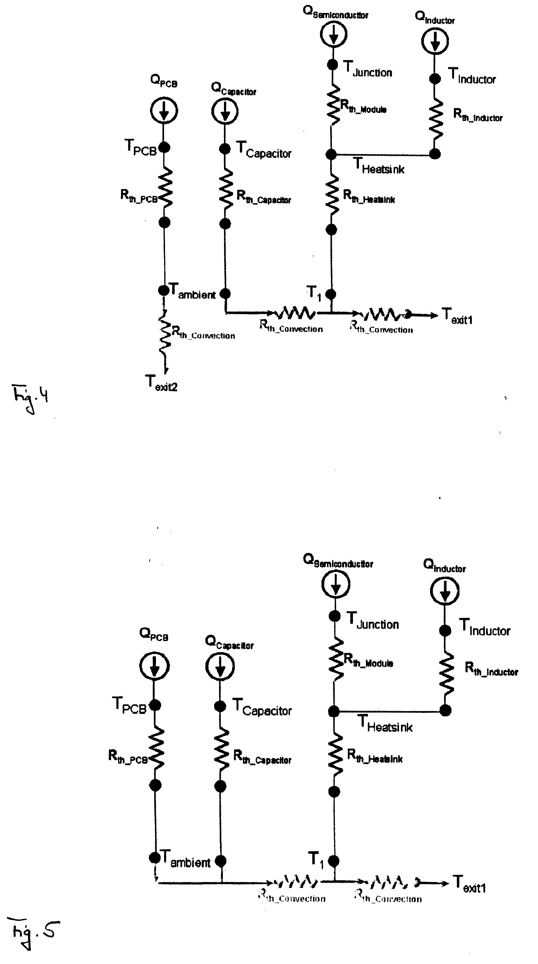

A thermal model of the arrangement shown in fig. 3 is given in fig. 4. In line with the illustration of fig. 3 it is shown that the printed circuit board 4 generates a first amount of heat indicated with $Q_{PCB}$ in fig. 4. This amount of heat is dissipated by the first airflow 7 inside the first area 1. First area 1 and second area 2 are separated from each other by means of a wall inside housing 3. The heat generated by capacitors 11 is denoted with $Q_{capacitor}$. This amount of heat is dissipated by the airflow after passing a thermal resistance $R_{th\_capacitor}$.

Further generated heat $Q_{semiconductor}$ and $Q_{inductor}$ of the power semiconductors 12 and the choke inductors 13 are both transferred in a first instance to the evaporator section 16 of the two-phase cooling circuit 15 as it is indicated by the common temperature $T_{heatsink}$ in the thermal model of fig. 4. The generated heat at first has to be conducted through the modules or components itself which is indicated by their individual thermal resistances $R_{th\_module}$ and

$R_{th\_inductor}$. The amount of heat that equals the sum of Qsemiconductor and $Q_{inductor}$ is then conducted by means of a heatsink to the evaporator section 16 as indicated by the thermal resistance $R_{th\_heatsink}$. The amount of heat is then conveyed to a location in the airflow 10 downstream the capacitors 11 where the condenser section 18 is arranged. The condenser section 18 has a temperature $T_1$ that might be higher than the maximum allowed temperature of capacitors 11.

The thermal resistance of the airflow 10 is again represented by a thermal resistance of a negative coefficient given by the equation:

$$R_{th\_convection}= (-1)/(C_p*DM/DT)$$

The layout of the electronic system is in no way limited to the given example. In order to emphasize this once more fig. 5 shows another example of a thermal model. In this example according to fig. 5 the printed circuit board 4 is also arranged in the common airflow of the other electronic components 11, 12, 13. Thus, the heat which equals the sum of the generated heat $Q_{PCB}$, $Q_{capacitor}$, Qsemiconductor and $Q_{inductor}$ is altogether dissipated by the common airflow 10. Such an arrangement is in particular possible, as the heat amount $Q_{PCB}$ of the printed circuit board 4 is relative small compared to the heat amount $Q_i$ of the other electronic components 11, 12, 13. In particular due to the improved airflow and thereby the reduced thermal resistance that characterizes the heat transfer from the heat generating or delivering elements such as capacitors 11 or condenser section 18 to the airflow 10 such a simplified embodiment with only one area is possible.

The invention is not limited to the illustrated embodiment. Individual features may also be combined advantageously.

**Claims**

1. Electronic system including a plurality of electronic components (11, 12, 13) each generating an individual amount of heat which is dissipated by means of a common airflow (10) wherein at least one of the plurality of electronic components (12, 13) is in thermal contact with an evaporator section (16) of a two-phase cooling circuit (15) with said two-phase cooling circuit (15) transferring the heat generated by the at least one electronic component (12, 13) in contact with said evaporator section (16) to a location in the airflow (10) distant from the location of generating this heat.

2. Electronic system according to claim 1,
   **characterized in that**
   the location in the airflow (10) is defined by an allowed temperature of those electronic components (11) arranged in the airflow (10) and a temperature of a condensing section (18) of said two-phase cooling circuit (15).

3. Electronic system according to claim 1 or 2,
   **characterized in that**
   at least part of the at least one electronic component (12, 13) in thermal contact with the evaporator section of said two-phase cooling circuit (15) is located outside of the airflow (10).

4. Electronic system according to claim 2,
   **characterized in that**
   the condensing section (18) comprises a condenser and a cooling element (20) in contact therewith and that the cooling element (20) is arranged to be located in the airflow.

5. Electronic system according to any of claims 1 to 4,
   **characterized in that**
   the airflow (10) is oriented in a vertical upward direction and that the electronic components (12, 13) being in thermal contact with the evaporator section (16) are arranged at an upstream end of the airflow (10).

6. Electronic system according to claim 5,
   **characterized in that**
   the airflow (10) is improved by means of an air fan (9).

7. Electronic system according to any of claims 1 to 6,

**characterized in that**
of the plurality of electronic components (11, 12, 13) those electronic components (12) are in thermal contact with the evaporator section (16) that generate the largest amount of heat and/or those electronic components (13) that cause the highest pressure drop when located in the airflow (10).

Fig. 1

Fig. 2

fig. 3

Fig.4

Fig.5

Europäisches
Patentamt

European
Patent Office

Office européen
des brevets

# EUROPEAN SEARCH REPORT

Application Number

EP 08 15 7001

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/168938 A1 (BASH CULLEN E [US] ET AL) 4 August 2005 (2005-08-04) | 1,2,4 | INV. H05K7/20 |
| Y | * paragraph [0020] - paragraph [0040]; figures 2-7 * | 3,5-7 | |
| | ----- | | |
| Y | US 2005/217829 A1 (BELITS ALEX [US] ET AL ALEX BELITS [US] ET AL) 6 October 2005 (2005-10-06) | 3 | |
| A | * paragraph [0055] - paragraph [0062]; figures 1-4 * | 1,2,4-7 | |
| | ----- | | |
| Y | US 2003/205363 A1 (CHU RICHARD C [US] ET AL) 6 November 2003 (2003-11-06) | 5-7 | |
| A | * paragraph [0042] - paragraph [0079]; figures 1,2A,2B,3,8,9A,9B,10,11 * | 1-4 | |
| | ----- | | |
| A | US 5 940 270 A (PUCKETT JOHN CHRISTOPHER [US]) 17 August 1999 (1999-08-17) * column 5, line 3 - column 6, line 46; figures 3,4 * | 1-7 | |
| | ----- | | |

TECHNICAL FIELDS
SEARCHED        (IPC)

H05K

| The present search report has been drawn up for all claims | | | |
|---|---|---|---|
| Place of search | Date of completion of the search | | Examiner |
| Munich | 27 October 2008 | | Drabko, Jacek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 08 15 7001

This annex lists the patent family members relating to the patent documents cited in the above-mentioned European search report.
The members are as contained in the European Patent Office EDP file on
The European Patent Office is in no way liable for these particulars which are merely given for the purpose of information.

27-10-2008

| Patent document cited in search report | | Publication date | Patent family member(s) | | Publication date |
|---|---|---|---|---|---|
| US 2005168938 | A1 | 04-08-2005 | NONE | | |
| US 2005217829 | A1 | 06-10-2005 | US 2007242438 | A1 | 18-10-2007 |
| US 2003205363 | A1 | 06-11-2003 | NONE | | |
| US 5940270 | A | 17-08-1999 | NONE | | |

EPO FORM P0459

For more details about this annex : see Official Journal of the European Patent Office, No. 12/82